# EUROPÄISCHE PATENTSCHRIFT

(11) **EP 4 441 461 B1**
(45) Veröffentlichungstag und Bekanntmachung des Hinweises auf die Patenterteilung: **16.07.2025**
(21) Anmeldenummer: 22785722.4
(22) Anmeldetag: 16.09.2022
(51) Int. Cl.: G01B 9/02, G02B 5/32, G02B 5/18, G01M 11/00, G03F 7/20, G03H 1/02, G03H 1/08, G03H 1/30

(54) **COMPUTER-GENERIERTES HOLOGRAMM (CGH), SOWIE VERFAHREN ZUR AUSLEGUNG EINES CGH**
COMPUTER-GENERATED HOLOGRAM (CGH), AND METHOD FOR DESIGNING A CGH
HOLOGRAMME GÉNÉRÉ PAR ORDINATEUR (CGH), ET PROCÉDÉ DE CONCEPTION D'UN CGH

(30) Priorität: 29.11.2021 DE 102021213383
(43) Veröffentlichungstag der Anmeldung: 09.10.2024
(73) Patentinhaber: Carl Zeiss SMT GmbH, 73447 Oberkochen (DE)
(72) Erfinder: SCHWARZ, Ingmar, 73447 Oberkochen (DE)
(74) Vertreter: Frank, Hartmut
(86) Internationale Anmeldenummer: PCT/EP2022/075863
(87) Internationale Veröffentlichungsnummer: WO 2023/094045

(56) Entgegenhaltungen:
- DE-A1- 102018 209 175
- DE-A1- 102019 212 520

## Beschreibung

Die vorliegende Anmeldung beansprucht die Priorität der Deutschen Patentanmeldung DE 10 2021 213 383.5, angemeldet am 29. November 2021.

### HINTERGRUND DER ERFINDUNG

### Gebiet der Erfindung

Die Erfindung betrifft ein Computer-generiertes Hologramm (CGH) zur Verwendung in einer interferometrischen Messanordnung, sowie ein Verfahren zur Auslegung eines CGH.

### Stand der Technik

Mikrolithographie wird zur Herstellung mikrostrukturierter Bauelemente, wie beispielsweise integrierter Schaltkreise oder LCD's, angewendet. Der Mikrolithographieprozess wird in einer sogenannten Projektionsbelichtungsanlage durchgeführt, welche eine Beleuchtungseinrichtung und ein Projektionsobjektiv aufweist. Das Bild einer mittels der Beleuchtungseinrichtung beleuchteten Maske (= Retikel) wird hierbei mittels des Projektionsobjektivs auf ein mit einer lichtempfindlichen Schicht (Photoresist) beschichtetes und in der Bildebene des Projektionsobjektivs angeordnetes Substrat (z.B. ein Siliziumwafer) projiziert, um die Maskenstruktur auf die lichtempfindliche Beschichtung des Substrats zu übertragen.

In für den EUV-Bereich ausgelegten Projektionsobjektiven, d.h. bei Wellenlängen von z.B. etwa 13 nm oder etwa 7 nm, werden mangels Verfügbarkeit geeigneter lichtdurchlässiger refraktiver Materialien Spiegel als optische Komponenten für den Abbildungsprozess verwendet. Typische für EUV ausgelegte Projektionsobjektive, wie z.B. aus US 2016/0085061 A1 bekannt, können beispielsweise eine bildseitige numerische Apertur (NA) im Bereich von NA = 0.55 aufweisen und bilden ein (z.B. ringsegmentförmiges) Objektfeld in die Bildebene bzw. Waferebene ab.

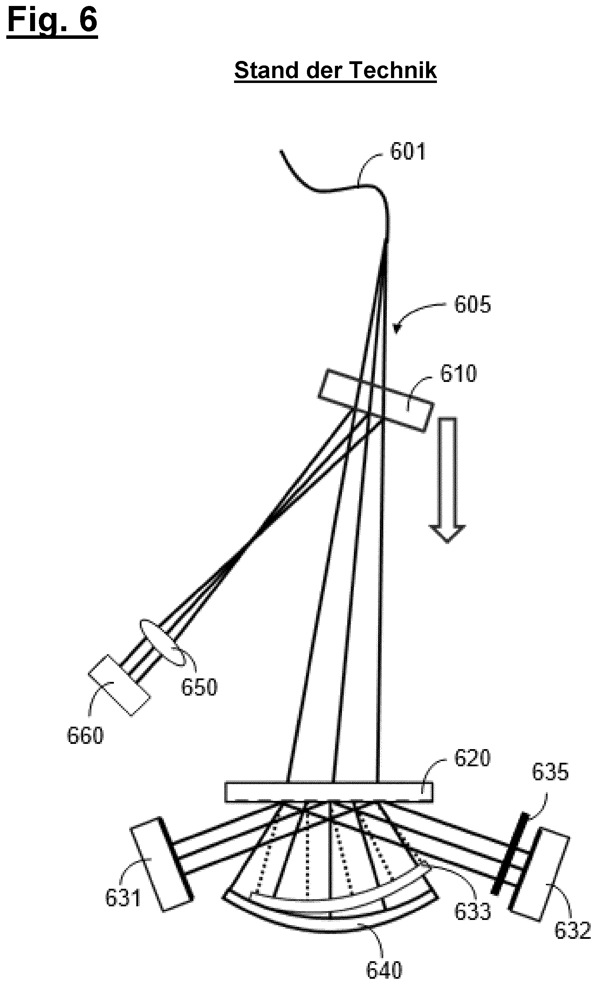

Mit der Erhöhung der bildseitigen numerischen Apertur (NA) geht typischerweise eine Vergrößerung der erforderlichen Spiegelflächen der in der Projektionsbelichtungsanlage eingesetzten Spiegel einher. Dies hat wiederum zur Folge, dass neben der Fertigung auch die Prüfung der Oberflächenform der Spiegel eine anspruchsvolle Herausforderung darstellt. Hierbei kommen zur hochgenauen Prüfung der Spiegel insbesondere interferometrische Messverfahren unter Verwendung Computer-generierter Hologramme (CGH) zum Einsatz. Fig. 6 zeigt eine schematische Darstellung zur Erläuterung eines beispielhaften möglichen Aufbaus einer interferometrischen Messanordnung zur Prüfung eines Spiegels.

Gemäß Fig. 6 tritt die von einer (nicht dargestellten) Lichtquelle erzeugte und aus der Austrittsfläche eines Lichtwellenleiters 601 austretende Beleuchtungsstrahlung als Eingangswelle 605 mit einer sphärischen Wellenfront aus, durchläuft einen Strahlteiler 610 und trifft anschließend auf ein komplex kodiertes CGH 620. Das CGH 620 erzeugt in Transmission im Beispiel gemäß seiner komplexen Kodierung aus der Eingangswelle 605 insgesamt vier Ausgangswellen, von denen eine Ausgangswelle als Prüfwelle auf die Oberfläche des Testobjekts in Form eines Spiegels 640 mit einer an die Sollform der Oberfläche dieses Spiegels 640 angepassten Wellenfront auftrifft. Des Weiteren erzeugt das CGH 620 aus der Eingangswelle 605 in Transmission drei weitere Ausgangswellen, von denen jede auf jeweils ein weiteres reflektives optisches Element 631, 632 bzw. 633 trifft. Mit "635" ist ein Shutter bezeichnet. Das CGH 620 dient auch zur Überlagerung der vom Testobjekt bzw. Spiegel 640 reflektierten Prüfwelle sowie der von den Elementen 631-633 reflektierten Referenzwellen, welche als konvergente Strahlen wieder auf den Strahlteiler 610 treffen und von diesem in Richtung einer als CCD-Kamera ausgelegten Interferometerkamera 660 reflektiert werden, wobei sie ein Okular 650 durchlaufen. Die Interferometerkamera 660 erfasst ein durch die interferierenden Wellen erzeugtes Interferogramm, aus welchem über eine (nicht dargestellte) Auswerteeinrichtung die tatsächliche Form der optischen Oberfläche des Testobjekts 640 bestimmt wird.

Ein in der Praxis auftretendes Problem ist, dass sich auf dem CGH ausbildende Kontaminationen (z.B. eines Wasser- oder Ölfilms) zu einer Änderung des jeweils gemessenen Interferogramms führen, so dass gegebenenfalls bei Feststellung einer Phasenabweichung in dem interferometrischen Messaufbau nicht mehr eindeutig unterscheidbar ist, ob die jeweilige Phasenabweichung auf vorhandene Kontaminationen auf dem CGH oder auf Formabweichungen der zu messenden Oberfläche zurückzuführen ist. Dies kann für eine auf der interferometrischen Messung basierende Fertigung eines optischen Elements bzw. Spiegels wiederum Fertigungsfehler (im Sinne einer Abweichung der jeweils gefertigten Oberfläche von der Zielgeometrie) zur Folge haben, wodurch letztlich die Performance des das jeweilige optische Element aufweisenden optischen Systems (z.B. der Projektionsbelichtungsanlage) beeinträchtigt wird. In der Praxis ergibt sich somit der Bedarf, auf dem CGH vorhandene Kontaminationen zu erfassen und in ihrem Einfluss auf das mit der jeweiligen interferometrischen Messanordnung erzielte Messergebnis zu berücksichtigen.

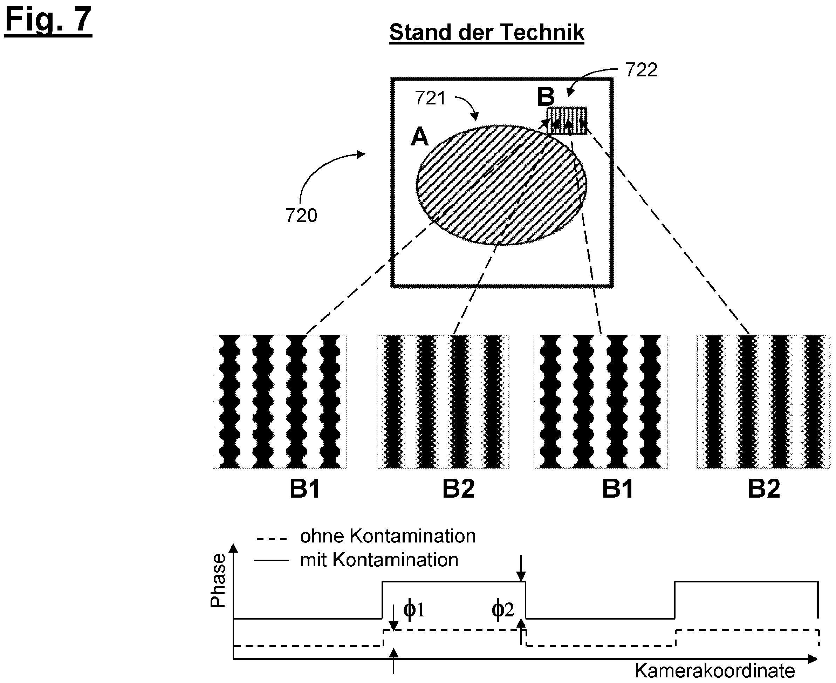

Ein hierzu bekannter Ansatz beinhaltet gemäß der schematischen Darstellung von Fig. 7 die Bereitstellung eines von der eigentlichen Nutzstruktur auf dem CGH räumlich separierten Kontrollbereichs mit sich hinsichtlich der jeweiligen Flankenfläche voneinander unterscheidenden Substrukturen, um aus einer unterschiedlichen Reaktion dieser Bereiche auf eine sich auf dem CGH ausbildende Kontamination und die dementsprechende veränderte Phasenwirkung die eindeutige Kontaminationsdetektion zu ermöglichen. Das in Fig. 7 dargestellte CGH 720 weist zusätzlich zu einem die eigentliche Nutzstruktur A zur Erzeugung der Prüfwelle bei der interferometrischen Messung umfassenden ersten Bereich 721 einen hiervon räumlich getrennten zweiten Bereich 722 auf, welcher als Kontrollbereich zur Detektion einer sich auf dem CGH 720 ausbildenden Kontamination dient. Um die von dem Kontrollbereich 722 in der interferometrischen Messanordnung ausgehenden Wellen ebenfalls bei der interferometrischen Messung erfassen zu können, sind Perioden der Gitterstrukturen des Kontrollbereichs 722 so ausgelegt, dass sie ebenfalls ein Interferogramm auf der Interferometerkamera erzeugen. Um innerhalb des Kontrollbereichs 722 eine kontaminationssensitive Funktionalität bereitzustellen, sind in besagtem Kontrollbereich 722 wenigstens zwei sich hinsichtlich der jeweiligen Flankenfläche voneinander unterscheidende Substrukturen B1 und B2 vorhanden.

Dabei kann in der Praxis das weitere Problem auftreten, dass trotz der vorstehend beschriebenen Bereitstellung unterschiedlicher Flankenflächen noch keine ausreichende Sensitivität auf Kontaminationen erreicht wird. Des Weiteren besteht in der Praxis auch ein Bedarf, die Erfassung und Berücksichtigung von auf einem CGH ausbildenden Kontaminationen in Szenarien zu realisieren, in denen die in den CGH-Strukturen vorhandenen Flankenwinkel bei der CGH-Fertigung nicht als freier Parameter zur Verfügung stehen (wenn etwa durchweg senkrecht zum CGH-Substrat ausgebildete CGH-Strukturen gefertigt werden sollen).

Auch angesichts der zu gewährleistenden hohen Reproduktionsgenauigkeit über die Laufzeit der interferometrischen Messanordnung stellt somit im Ergebnis die angemessene Berücksichtigung von sich auf den CGH ausbildenden Kontaminationen eine anspruchsvolle Herausforderung dar.

Zum Stand der Technik wird lediglich beispielhaft auf DE 10 2018 209 175 A1 verwiesen.

### ZUSAMMENFASSUNG DER ERFINDUNG

Vor dem obigen Hintergrund ist es eine Aufgabe der vorliegenden Erfindung, ein Computer-generiertes Hologramm (CGH) zur Verwendung in einer interferometrischen Messanordnung sowie ein Verfahren zur Auslegung eines Computer-generierten Hologramms bereitzustellen, welche in einer interferometrischen Messanordnung eine ausreichende Messgenauigkeit unter zumindest teilweiser Vermeidung der vorstehend beschriebenen Probleme ermöglichen.

Diese Aufgabe wird durch das Computer-generierte Hologramm (CGH) gemäß den Merkmalen des unabhängigen Patentanspruchs 1 bzw. das Verfahren gemäß den Merkmalen des nebengeordneten Patentanspruchs 9 gelöst.

Gemäß einem Aspekt der Erfindung weist ein Computer-generiertes Hologramm (CGH) zur Verwendung in einer interferometrischen Messanordnung wenigstens eine Nutzstruktur sowie eine Kontaminationsmarker-Anordnung zur Detektion einer auf dem CGH vorhandenen Kontamination auf, wobei diese Kontaminationsmarker-Anordnung aufweist:
- eine erste Kontaminationsmarker-Struktur mit einer ersten Substruktur und einer zweiten Substruktur, welche sich hinsichtlich der jeweils durch eine vorgegebene Kontamination bewirkten Wellenfrontänderung voneinander unterscheiden; und
- wenigstens eine zweite Kontaminationsmarker-Struktur mit einer dritten Substruktur und einer vierten Substruktur, welche sich hinsichtlich der jeweils durch eine vorgegebene Kontamination bewirkten Wellenfrontänderung voneinander unterscheiden;
- wobei jede der Substrukturen in komplexer Kodierung wenigstens ein erstes Teilgitter zur Bereitstellung wenigstens einer zur Interferogramm-Erzeugung beitragenden ersten Ausgangswelle und wenigstens ein Dummy-Gitter zur Erzeugung einer nicht zur Interferogramm-Erzeugung beitragenden Ausgangswelle aufweist;
- wobei sich die dritte Substruktur und/oder die vierte Substruktur sowohl von der ersten Substruktur als auch von der zweiten Substruktur hinsichtlich des Dummy-Gitters und/oder des relativen Gewichtes von Teilgittern und Dummy-Gitter und/oder des Füllfaktors voneinander unterscheiden; und
- wobei die wenigstens zwei Kontaminationsmarker-Strukturen der Kontaminationsmarker-Anordnung jeweils im Wege einer modellbasierten Suche ermittelte Strukturen sind, wobei die Dummy-Struktur für ein vorgegebenes erstes Teilgitter zur Bereitstellung einer zur Interferogramm-Erzeugung beitragenden ersten Ausgangswelle durch die modellbasierte Suche numerisch optimiert ist.

Das CGH weist eine komplexe Kodierung zur Erzeugung unterschiedlicher Ausgangswellen auf. Hinsichtlich der komplexen Kodierung wird lediglich beispielhaft auf die Publikationen F. Simon et al: "Quasi-absolute measurement of aspheres with a combined diffractive optical element as reference", APPLIED OPTICS Vol. 45. No. 34, 2006, S. 8606-8612, H. Liu et al: "Redistribution of output weighting coefficients for complex multiplexed phase-diffractive elements", OPTICS EXPRESS Vol. 12, No. 19, 2004, S. 4347-4352 und E. Carcolé et al: "Derivation of weighting coefficients for multiplexed phase-diffractive elements", OPTICS LETTERS Vol. 20, No. 23, 1995, S. 2360-2362 verwiesen.

Gemäß einer Ausführungsform besitzt wenigstens eine der Kontaminationsmarker-Strukturen eine Kontaminations-Sensitivität, welche wenigstens das Zweifache, insbesondere wenigstens das Fünffache, weiter insbesondere wenigstens das Zehnfache, und weiter insbesondere wenigstens das Zwanzigfache der Kontaminations-Sensitivität der Nutzstruktur beträgt. Dabei ist hier und im Folgenden die Kontaminations-Sensitivität einer Nutzstruktur oder einer Substruktur als Verhältnis aus einer durch eine vorgegebene Kontamination mit definierter Kontaminationsschichtdicke bedingten Wellenfrontänderung in dem durch das CGH im Betrieb erzeugten Interferogramm zu besagter Kontaminationsschichtdicke definiert. Die Kontaminations-Sensitivität einer Kontaminationsmarker-Struktur entspricht dann der Differenz der Wellenfrontsensitivitäten der zugehörigen Substrukturen.

Die Kontaminations-Sensitivität der Kontaminationsmarker-Struktur kann insbesondere durch geeignete Wahl eines Dummy-Gitters dahingehend erreicht werden, dass die Abhängigkeit der erzeugten Interferogrammphase von Kontaminationen möglichst groß ist. Die Erfindung beinhaltet hierbei das Prinzip, ausgehend von vorgegebenen (durch die Gitterstruktur des wenigstens einen ersten Teilgitters bereitgestellten) Grundfunktionalitäten die Kontaminations-Sensitivität dadurch in geeigneter Weise einzustellen bzw. zu optimieren, dass eine weitere durch das Dummy-Gitter bereitgestellte "Dummy-Struktur" (welche selbst nicht interferometrisch wirksam ist, sondern Licht aus dem Nutzstrahlengang auskoppelt) genutzt wird.

Gemäß einer Ausführungsform erzeugt jede der Substrukturen dieser Kontaminationsmarker-Struktur bei einer in der Messanordnung durchgeführten interferometrischen Messung einen Interferenzkontrast von wenigstens 10 %, insbesondere wenigstens 30 %, weiter insbesondere wenigstens 50 %, weiter insbesondere wenigstens 70 %.

In Ausführungsformen der Erfindung sind die wenigstens zwei Kontaminationsmarker-Strukturen für voneinander verschiedene Fertigungsabweichungen ausgelegt. Die "Auslegung einer Kontaminationsmarker-Struktur für eine Fertigungsabweichung" kann hierbei insbesondere bedeuten, dass eine Merit-Funktion verwendet bzw. optimiert wird, die einen kontinuierlichen Kompromiss zwischen Kontaminationssensitivität, Helligkeit, Kontrast, Tastverhältnis und ggf. weiteren Parametern beschreibt.

Die "Auslegung einer Kontaminationsmarker-Struktur für eine Fertigungsabweichung" bedeutet vorzugsweise insbesondere, dass folgende Anforderungen erfüllt sind: Zum einen weist die Kontaminationsmarker-Struktur für die jeweilige Fertigungsabweichung (d.h. das Vorliegen bestimmter Werte für einen oder mehrere vorgegebene Strukturparameter, beispielsweise unterschiedliche fertigungsbedingt resultierende Werte für den Kantenversatz und die Ätztiefe der Kontaminationsmarker-Strukturen) eine ausreichend hohe Kontaminations-Sensitivität auf. Zum anderen erzeugt die Kontaminationsmarker-Struktur in dem durch das CGH im Betrieb erzeugten und von der Interferometerkamera in der interferometrischen Messanordnung erfassten Interferogramm für die jeweilige Fertigungsabweichung auch einen ausreichenden Kontrast sowie eine ausreichende Helligkeit.

Dabei können insbesondere zunächst die zu erwartenden Fertigungsabweichungen mit dem größten Einfluss auf die Kontaminations-Sensitivität bestimmt werden, wobei die Auslegung der ersten und wenigstens zweiten Kontaminationsmarker-Struktur dann für diese Fertigungsabweichungen erfolgen können.

Dabei geht die Erfindung u.a. auch von der Überlegung aus, dass die von einer Gitterstruktur eines CGH bereitgestellte Kontaminations-Sensitivität zwar durch jeweils geeignete bzw. optimierte Wahl der "freien Parameter", nämlich Füllfaktor und relatives Gewicht, optimiert werden kann, sich diese Optimierung allein aber gleichwohl als unzureichend erweisen kann:
Dies gilt zum einen, weil eine starke Abhängigkeit des Wertes der Kontaminations-Sensitivität etwa von der Orientierung der Gitterstrukturen gegeben ist mit der Folge, dass bei einer bestimmten ungünstigen Orientierung die Kontaminations-Sensitivität trotz "optimaler" Wahl von Füllfaktor und relativem Gewicht ggf. immer noch einen zu niedrigen absoluten Wert besitzt. Dies gilt zum anderen aber auch, weil für das in dem durch das CGH im Betrieb erzeugten und von der Interferometerkamera in der interferometrischen Messanordnung erfasste Interferogramm zusätzliche Kriterien wie z.B. Kontrast oder Helligkeit zu fordern sind (da auch ein hoher Wert der Kontaminations-Sensitivität bei zugleich zu geringem Kontrast oder zu geringer Helligkeit nicht mehr von Nutzen ist).

Des Weiteren geht die Erfindung auch von der Überlegung aus, dass die Kontaminations-Sensitivität des CGH stark von der Form des ausgewählten Dummy-Gitters (nicht nur seiner Flanken-Fläche), von den relativen Gewichten der Teilgitter und von dem Füllfaktor abhängt mit der Folge, dass bereits Parameteränderungen infolge von Fertigungsfehlern das Erreichen einer ausreichend hohen Kontaminations-Sensitivität zunichtemachen können.

Als Konsequenz aus den vorstehenden Überlegungen kann nun erfindungsgemäß zum einen eine modellbasierte Optimierung freier Gitterparameter (zur Erzielung eines geeigneten Kompromisses zwischen Kontaminationssensitivität, Helligkeit, Kontrast, Tastverhältnis und ggf. weiteren Parametern) durchgeführt werden, und es werden zum anderen auch Kontaminationsmarker-Strukturen für voneinander verschiedene Fertigungsabweichungen bereitgestellt, um auf diese Weise sicherzustellen, dass sich für eine tatsächlich in der Praxis vorliegende Fertigungsabweichung - trotz genannter starker Abhängigkeit der Kontaminations-Sensitivität z.B. von der Orientierung der Gitterstrukturen - eine nicht nur hinsichtlich der freien Parameter (Füllfaktor und relatives Gewicht) optimierte, sondern auch in absoluter Hinsicht ausreichende Kontaminations-Sensitivität ergibt. Mit anderen Worten wird erreicht, dass unabhängig von der in einem konkreten Anwendungsszenario tatsächlich vorliegenden Fertigungsabweichung immer eine ausreichend hohe Kontaminations-Sensitivität bei ausreichendem Kontrast sowie ausreichender Helligkeit vorhanden ist, da nämlich für jedes in Betracht kommende Anwendungsszenario eine entsprechende Kontaminationsmarker-Struktur vorhanden ist.

Eine "Kontaminationsmarker-Struktur" ist im Sinne der vorliegenden Anmeldung eine Einheit, die für eine vorgegebene Fertigungsabweichung ausgelegt werden kann und eine von justagebedingten Wellenfrontverläufen verschiedene kontaminationsabhängige Wellenfrontsignatur im während des Betriebs erzeugten Interferogramm aufweist. Dies kann z.B. durch eine kontinuierliche Variation der Gitterstruktur über die betreffende Kontaminationsmarker-Struktur erreicht werden, wobei diese Variation der Gitterstruktur beispielsweise in Form eines Astigmatismus oder auch als Zufallsvariation ausgestaltet sein kann. Dabei können die Strukturparameter für eine maximal positive und eine maximal negative Kontaminations-Sensitivität berechnet und in Form der gewünschten Signatur interpoliert werden. Weiter können auch zwei zusammengehörende Sub-Bereiche bzw. Sub-Patches gemeinsam eine Kontaminationsmarker-Struktur bilden.

In diesem Falle kann einer dieser Sub-Bereiche die maximal positive Kontaminations-Sensitivität und der andere die maximal negative Kontaminations-Sensitivität aufweisen.

Gemäß einer Ausführungsform weist die Kontaminationsmarker-Anordnung eine Mehrzahl von in einem Array angeordneten Kontaminationsmarker-Strukturen mit jeweils einer ersten Substruktur und einer zweiten Substruktur auf. Auf diese Weise kann insbesondere wie vorstehend beschrieben ein Array aus einer Mehrzahl von für voneinander verschiedene vorgegebene Fertigungsabweichungen ausgelegten Kontaminationsmarker-Strukturen gebildet werden.

Gemäß einer Ausführungsform können Sub-Bereiche mit positiver Kontaminations-Sensitivität und Sub-Bereiche mit negativer Kontaminations-Sensitivität alternierend angeordnet sein, um ein möglichst gut detektierbares Signal zu erhalten.

Gemäß einer Ausführungsform weist jede der Substrukturen zusätzlich zum ersten Teilgitter ein zweites Teilgitter zur Bereitstellung einer zur Interferogramm-Erzeugung beitragenden zweiten Ausgangswelle als Referenzwelle auf. Das zweite Teilgitter kann insbesondere als Littrow-Struktur ausgestaltet sein, so dass die zweite Ausgangswelle bzw. Referenzwelle direkt am CGH als Littrow-Welle in Reflexion erzeugt wird. In einer weiteren Ausführungsform kann die zweite Ausgangswelle vom CGH auch in Transmission erzeugt und auf einen Referenzspiegel gelenkt werden.

Die Erfindung ist jedoch nicht auf eine durch das CGH erfolgende Bereitstellung einer zur Interferogramm-Erzeugung beitragenden zweiten Ausgangswelle als Referenzwelle beschränkt, wobei insbesondere eine Referenzwelle auch in einer sogenannten Fizeau-Anordnung über ein zusätzliches Fizeau-Element erzeugt werden kann (in diesem Falle also das erfindungsgemäße CGH bzw. die genannten Substrukturen keine zweite Ausgangswelle als Referenzwelle erzeugen müssen).

Gemäß einer Ausführungsform weist das CGH einen die wenigstens eine Nutzstruktur aufweisenden ersten Bereich und einen von diesem ersten Bereich räumlich separierten zweiten Bereich auf, wobei die Kontaminationsmarker-Anordnung in dem zweiten Bereich angeordnet ist.

Gemäß einer Ausführungsform ist das CGH zum Prüfen eines optischen Elements einer mikrolithographischen Projektionsbelichtungsanlage ausgelegt.

Die Erfindung betrifft weiter ein Verfahren zur Auslegung eines Computer-generierten Hologramm (CGH) mit einer Kontaminationsmarker-Anordnung, wobei die Kontaminationsmarker-Anordnung eine erste Kontaminationsmarker-Struktur mit einer ersten Substruktur und einer zweiten Substruktur, welche sich hinsichtlich der durch eine vorgegebene Kontamination jeweils bewirkten Wellenfrontänderung voneinander unterscheiden, und wenigstens eine zweite Kontaminationsmarker-Struktur mit einer dritten Substruktur und einer vierten Substruktur, welche sich hinsichtlich der jeweils durch eine vorgegebene Kontamination bewirkten Wellenfrontänderung voneinander unterscheiden, wobei jede der Substrukturen in komplexer Kodierung wenigstens ein erstes Teilgitter zur Bereitstellung einer zur Interferogramm-Erzeugung beitragenden ersten Ausgangswelle und wenigstens ein Dummy-Gitter zur Erzeugung einer nicht zur Interferogramm-Erzeugung beitragenden Ausgangswelle aufweist, wobei die wenigstens zwei Kontaminationsmarker-Strukturen der Kontaminationsmarker-Anordnung jeweils im Wege einer modellbasierten Suche ermittelt werden, wobei bei dieser modellbasierten Suche eine numerische Optimierung der Dummy-Struktur für ein vorgegebenes erstes Teilgitter zur Bereitstellung einer zur Interferogramm-Erzeugung beitragenden ersten Ausgangswelle durchgeführt wird.

Gemäß einer Ausführungsform kann bei der modellbasierten Suche eine numerische Optimierung der Dummy-Struktur auch für weitere vorgegebene Gitterstrukturen durchgeführt werden.

Gemäß einer Ausführungsform wird diese numerische Optimierung derart durchgeführt, dass die Kontaminations-Sensitivität der durch die wenigstens eine durch das CGH bereitgestellte Ausgangswelle und die Referenzwelle erzeugten Interferogrammphase unter vorgegebenen Randbedingungen maximiert wird. Wesentlich ist dabei, dass eine Reihe von Randbedingungen hinsichtlich der Eigenschaften des resultierenden Interferogramms erfüllt werden. So sollte beispielsweise die Helligkeit in einem bestimmten Bereich bleiben und der Interferenz-Kontrast einen Minimalwert nicht unterschreiten. Daher kann in Ausführungsformen anstelle des die maximale Sensitivität ergebenden Dummy-Gitters ein Dummy-Gitter gewählt werden, welche die Merit-Funktion maximiert (wobei in dieser Merit-Funktion die Sensitivität wiederum einen wesentlichen Faktor darstellt).

Die Offenbarung ist nicht auf die vorstehend beschriebene modellbasierte Suche zur Erzeugung der Kontaminationsmarker-Anordnung beschränkt, wobei solche anderen Ausführungen jedoch nicht unter den Schutzbereich der Ansprüche fallen. In weiteren Ausführungsformen kann auch für eine "Zufalls-Struktur" (d.h. eine nicht gezielt ausgelegte Kontaminationsmarker-Struktur) die Kontaminations-Sensitivität durch Messung unter kontrollierten Kontaminationsbedingungen bestimmt werden. Da diese Kontaminationsmarker-Struktur dann nicht im Wege einer modellbasierten Suche gezielt "ausgelegt" ist, wird eine entsprechend größere Kontaminationsmarker-Gesamtfläche benötigt, um eine ausreichende Anzahl von Werten für die Gewichte und Tastverhältnisse sowie eine ausreichende Anzahl von Dummy-Gittern abzudecken bzw. bereitzustellen, um so statistisch eine ausreichende Performance im Sinne einer hinreichenden Kontaminations-Sensitivität unter den gegebenen Randbedingungen zu erreichen.

Die Erfindung betrifft weiter auch eine interferometrische Messanordnung zum Prüfen eines optischen Elements, insbesondere eines optischen Elements einer mikrolithographischen Projektionsbelichtungsanlage, wobei die Messanordnung ein Computer-generiertes Hologramm (CGH) aufweist und wobei eine Prüfung zumindest einer Teilfläche des optischen Elements durch interferometrische Überlagerung einer von diesem Computer-generierten Hologramm auf das optische Element gelenkten Prüfwelle und einer Referenzwelle durchführbar ist, wobei das Computer-generiertes Hologramm (CGH) gemäß den vorstehend beschriebenen Merkmalen ausgelegt ist.

Weitere Ausgestaltungen der Erfindung sind der Beschreibung sowie den Unteransprüchen zu entnehmen.

Die Erfindung wird nachstehend anhand von in den beigefügten Abbildungen dargestellten Ausführungsbeispielen näher erläutert.

### KURZE BESCHREIBUNG DER ZEICHNUNGEN

Es zeigen:
- Figur 1: ein Flussdiagramm zur Erläuterung einer Ausführungsform der vorliegenden Erfindung;
- Figur 2-5: schematische Darstellungen zur Erläuterung beispielhafter Ausführungsformen der vorliegenden Erfindung;
- Figur 6: eine schematische Darstellung eines möglichen Aufbaus einer interferometrischen Messanordnung;
- Figur 7: eine schematische Darstellung zur Erläuterung eines beispielhaften herkömmlichen Ansatzes zur Detektion einer auf einem CGH vorhandenen Kontamination; und
- Figur 8: eine schematische Darstellung einer für den Betrieb im EUV ausgelegten Projektionsbelichtungsanlage.

### DETAILLIERTE BESCHREIBUNG BEVORZUGTER AUSFÜHRUNGSFORMEN

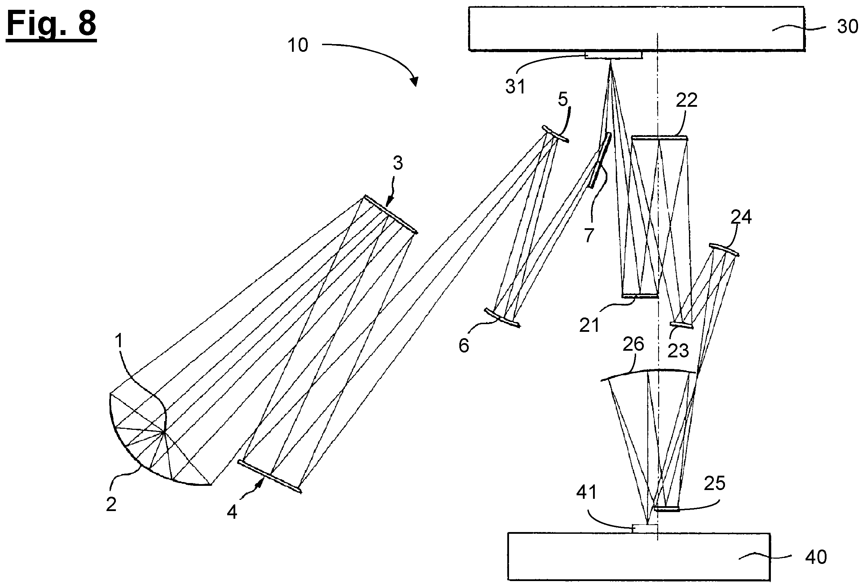

Fig. 8 zeigt zunächst eine schematische Darstellung einer beispielhaften für den Betrieb im EUV ausgelegten Projektionsbelichtungsanlage, welche mit einer interferometrischen Messanordnung (z.B. mit dem anhand von Fig. 6 bereits beschriebenen Aufbau) prüfbare Spiegel aufweist.

Gemäß Fig. 8 weist eine Beleuchtungseinrichtung in einer für EUV ausgelegten Projektionsbelichtungsanlage 10 einen Feldfacettenspiegel 3 und einen Pupillenfacettenspiegel 4 auf. Auf den Feldfacettenspiegel 3 wird das Licht einer Lichtquelleneinheit, welche eine Plasmalichtquelle 1 und einen Kollektorspiegel 2 umfasst, gelenkt. Im Lichtweg nach dem Pupillenfacettenspiegel 4 sind ein erster Teleskopspiegel 5 und ein zweiter Teleskopspiegel 6 angeordnet. Im Lichtweg nachfolgend ist ein Umlenkspiegel 7 angeordnet, der die auf ihn treffende Strahlung auf ein Objektfeld in der Objektebene eines sechs Spiegel 21-26 umfassenden Projektionsobjektivs lenkt. Am Ort des Objektfeldes ist eine reflektive strukturtragende Maske 31 auf einem Maskentisch 30 angeordnet, die mit Hilfe des Projektionsobjektivs in eine Bildebene abgebildet wird, in welcher sich ein mit einer lichtempfindlichen Schicht (Photoresist) beschichtetes Substrat 41 auf einem Wafertisch 40 befindet.

Bei dem in einer interferometrischen Messanordnung und unter Verwendung eines erfindungsgemäßen CGHs geprüften optischen Element kann es sich z.B. um einen beliebigen Spiegel der Projektionsbelichtungsanlage 10 handeln.

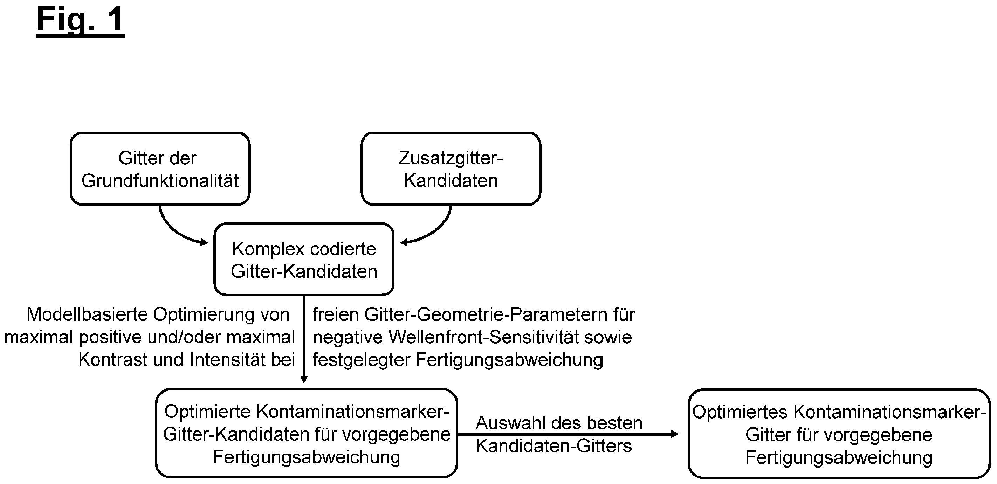

Im Weiteren werden Ausführungsformen der Erfindung unter Bezugnahme auf die schematischen Abbildungen in Fig. 1-5 beschrieben.

Den im Weiteren beschriebenen Ausführungsformen ist gemeinsam, dass ein zur Verwendung in einer interferometrischen Messanordnung bestimmtes CGH zwecks Detektion bzw. Berücksichtigung einer sich im Betrieb auf dem CGH ausbildenden Kontamination eine Kontaminationsmarker-Anordnung aufweist, wobei deren Funktionsprinzip grundsätzlich - insoweit analog zu dem eingangs anhand von Fig. 7 beschriebenen herkömmlichen Ansatz - auf der mit einer Ausbildung einer Kontaminationsschicht auf dem CGH einhergehenden Änderung der Wellenfront- bzw. Phasenwirkung des CGH basiert.

Im Unterschied zum herkömmlichen Ansatz gemäß Fig. 7 beruht die Erfindung jedoch nicht auf der Nutzung unterschiedlicher Flankenflächenanteile, sondern vielmehr auf der Nutzung einer modellbasierten Optimierung von Kontaminationsmarker-Strukturen. Diese modellbasierte Optimierung beinhaltet konkret die modellbasierte Suche bestimmter (Dummy-)Gitterstrukturen, welche bei Auftreten von Kontaminationen zu einer Modulation von wenigstens einer durch das CGH bereitgestellten Ausgangswelle und damit einer Modulation der sich aus der Überlagerung zwischen dieser wenigstens einen Ausgangswelle und der Referenzwelle erzeugten Interferogrammphase führt.

Mit anderen Worten wird die erfindungsgemäße modellbasierte Optimierung für grundsätzlich freie Gitterparameter (nämlich Füllfaktor und relative Gewichte) durchgeführt mit dem Ziel, für die vorgegebene komplexe Kodierung des CGH's und unterschiedliche Fertigungsabweichungen des CGH's (welche beispielsweise bestimmte Werte für den Kantenversatz, die Ätztiefe und/oder das Tastverhältnis beinhalten können) eine möglichst hohe Kontaminations-Sensitivität (im Sinne einer durch die jeweilige Kontamination bewirkte Wellenfront- bzw. Phasenänderung) bei zugleich ausreichenden Werten für Kontrast und Intensität zu erzielen.

Die erfindungsgemäße modellbasierte Optimierung beinhaltet jeweils detaillierte Simulationen der Maxwell-Gleichungen zur Ermittlung der Beugungswirkung der (typischerweise komplex kodierten) Gitterstrukturen in der Kontaminationsmarker-Anordnung. Konkret wird dabei gemäß Fig. 1 nach einem oder mehreren optimalen "Zusatzgittern" gesucht, die bei komplexer Kodierung zusammen mit den jeweiligen Gitterstrukturen der Interferogramm-Grundfunktionalität (d.h. den jeweils interferometrisch wirksamen Gitterstrukturen) eine maximale Kontaminations-Sensitivität der Wellenfront bzw. Phasenwirkung führen. Der zugrundeliegende physikalische Wirkmechanismus ist hierbei, dass durch die Kopplung elektromagnetischer Moden in komplex kodierten Gitterstrukturen Resonanzen entstehen, welche wiederum eine hohe Wellenfront-Wirkung erzeugen. Die durch die jeweilige Gitterstruktur induzierte Kopplung lässt sich ihrerseits wiederum durch Kontamination modulieren. Durch den Einsatz einer numerischen Optimierung der komplex kodierten Kontaminationsmarker-Strukturen lassen sich entsprechend Kontaminationsmarker-Strukturen mit hoher Kontaminations-Sensitivität realisieren.

Lediglich beispielhaft kann es sich bei den vorstehend genannten interferometrisch wirksamen Gitterstrukturen auf dem CGH um Gitterstrukturen handeln, von denen die eine Gitterstruktur eine Prüfwelle als Ausgangswelle bereitstellt, wohingegen die andere Gitterstruktur als Littrow-Struktur ausgestaltet ist. Bei besagter nicht interferometrisch wirksamer Gitterstruktur kann es sich um eine grundsätzlich zur Auskopplung von Licht aus dem Nutzlichtstrahlengang dienende Dummy-Struktur handeln, deren kontaminationssensitivitäts-bestimmende Eigenschaft darauf basiert, dass sie die Kopplung der durch das CGH erzeugten Moden sowie deren Kontaminationsabhängigkeit beeinflusst.

Gemäß einem weiteren Aspekt wird die erfindungsgemäße Kontaminationsmarker-Anordnung derart ausgestaltet, dass für voneinander verschiedene vorgegebene Fertigungsabweichungen jeweils geeignete Kontaminationsmarker-Strukturen ausgelegt werden mit dem Ziel, dass für eine in der Praxis dann tatsächlich vorhandene Fertigungsabweichung auch in jedem Falle eine hinreichend kontaminationssensitive Kontaminationsmarker-Struktur vorhanden ist. Die "Auslegung" einer Kontaminationsmarker-Struktur für eine Fertigungsabweichung bedeutet hierbei, dass eine Merit-Funktion verwendet bzw. optimiert wird, die einen kontinuierlichen Kompromiss zwischen Sensitivität, Helligkeit, Kontrast, Tastverhältnis und ggf. weiteren Parametern beschreibt. Dabei weist die Kontaminationsmarker-Struktur für die jeweilige Fertigungsabweichung (d.h. das Vorliegen bestimmter Werte für einen oder mehrere vorgegebene Strukturparameter) vorzugsweise eine unter Berücksichtigung der besagten weiteren Parameter möglichst hohe Kontaminations-Sensitivität auf. Dabei können insbesondere zunächst die zu erwartenden Fertigungsabweichungen mit dem größten Einfluss auf die Kontaminations-Sensitivität bestimmt werden.

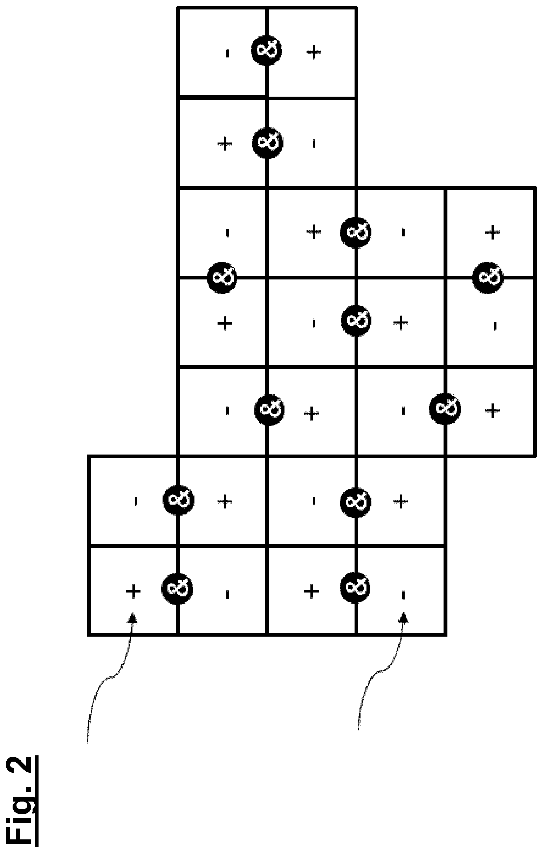

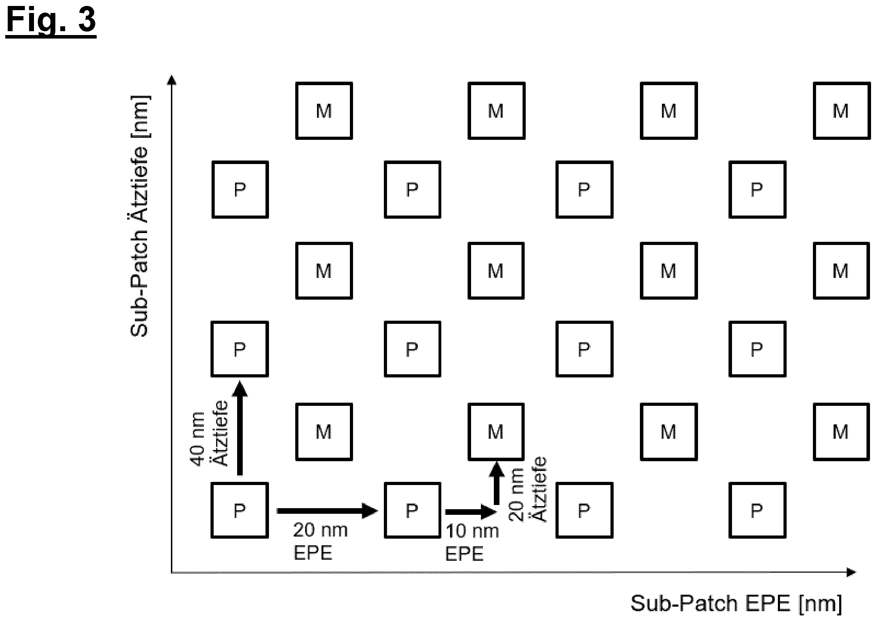

Die besagten Kontaminationsmarker-Strukturen können weiter insbesondere in räumlich separaten Sub-Bereichen (= "Sub-Patches") auf dem CGH vorhanden sein, wozu Fig. 3 lediglich schematisch eine beispielhafte mögliche Ausgestaltung zeigt. Fig. 3 zeigt dabei keine räumliche Anordnung auf dem CGH, sondern eine Verteilung der Fertigungsabweichungs-Größen für die einzelnen Sub-Patches aus Fig. 2. Dabei sind mit "M" jeweils Fertigungsabweichungs-Arbeitspunkte entsprechender Sub-Bereiche mit negativer Kontaminations-Sensitivität und mit "P" Fertigungsabweichungs-Arbeitspunkte bzw. entsprechende Sub-Bereiche mit positiver Kontaminations-Sensitivität bezeichnet.

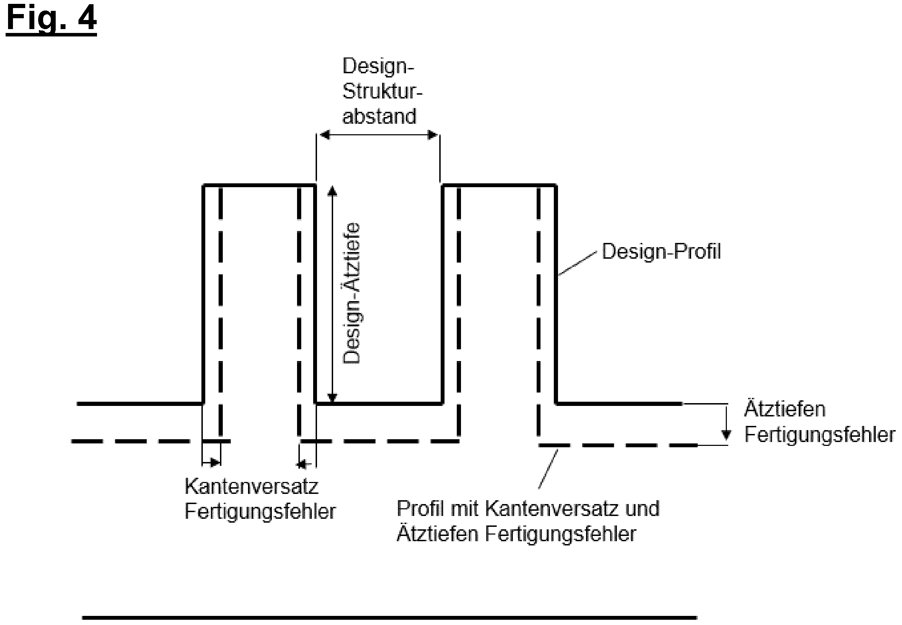

Hierbei kann es sich, ohne dass die Erfindung hierauf beschränkt wäre, bei den über die besagten Sub-Bereiche variierten Strukturparametern bzw. Fertigungsfehlern um den Kantenversatz (EPE = "**E**dge **P**lacement **E**rror") sowie die Ätztiefe handeln, wie in der schematischen Darstellung von Fig. 4 veranschaulicht. Dabei kann wiederum beispielhaft der Wert der Ätztiefe für die besagten Sub-Bereiche zwischen 500 nm und 600 nm variiert werden, wohingegen der Kantenversatz lediglich beispielhaft zwischen -40 nm und +40 nm variiert werden kann.

Des Weiteren können gemäß der schematischen Darstellung von Fig. 2 Sub-Bereiche positiver und negativer Kontaminations-Sensitivität (d.h. positiver oder negativer kontaminationsbedingter Wellenfrontänderung abhängig von der Kontaminationsschichtdicke) alternierend in einem Array angeordnet werden. Eine solche Ausgestaltung ist insofern vorteilhaft, als eine maximale Kontaminations-Sensitivität des Differenzsignals benachbarter Sub-Bereiche erhalten wird. Des Weiteren erzeugt eine solche Anordnung eine von anderen Signalverläufen des in der Messanordnung erzeugten Interferogramms ohne Weiteres unterscheidbare Signatur, wodurch wiederum eine fehlerhafte Ursachenzuordnung vermieden werden kann.

Die Erfindung ist nicht auf eine regelmäßige alternierende Anordnung der genannten Sub-Bereiche eingeschränkt. Insbesondere können auch anstatt positiver bzw. negativer Kontaminations-Sensitivitäten kontinuierliche Sensitivitätsverläufe durch geeignete Wahl der jeweiligen Strukturparameter erzeugt werden. Beispiele sind Wellenfrontverläufe in Form eines Astigmatismus oder auch zufällige Wellenfrontvariationen über die Kontaminationsmarker-Struktur, welche sich von justagebedingten Wellenfrontverläufen unterscheiden lassen.

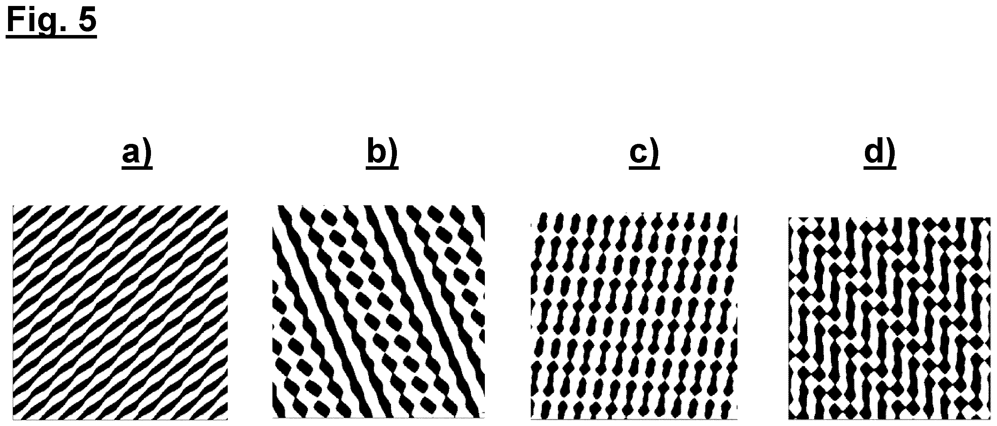

Fig. 5a-5d zeigen Darstellungen beispielhafter, erfindungsgemäß optimierter Kontaminationsmarker-Strukturen in komplexer Kodierung. Die weiß dargestellten Bereiche zeigen Stege bzw. Erhebungen und die schwarz dargestellten Bereiche zeigen Furchen bzw. Löcher. Typische Grabenbreiten liegen im Bereich von etwa 0.2 µm bis etwa 10 µm.

Wenn die Erfindung auch anhand spezieller Ausführungsformen beschrieben wurde, erschließen sich für den Fachmann zahlreiche Variationen und alternative Ausführungsformen, z.B. durch Kombination und/oder Austausch von Merkmalen einzelner Ausführungsformen. Dementsprechend versteht es sich für den Fachmann, dass derartige Variationen und alternative Ausführungsformen von der vorliegenden Erfindung mit umfasst sind und die Reichweite der Erfindung nur im Sinne der beigefügten Patentansprüche beschränkt ist.

## Patentansprüche

1. Computer-generiertes Hologramm (CGH) zur Verwendung in einer interferometrischen Messanordnung, mit wenigstens einer Nutzstruktur sowie einer Kontaminationsmarker-Anordnung zur Detektion einer auf dem CGH vorhandenen Kontamination, wobei diese Kontaminationsmarker-Anordnung aufweist:
• eine erste Kontaminationsmarker-Struktur mit einer ersten Substruktur und einer zweiten Substruktur, welche sich hinsichtlich der durch eine vorgegebene Kontamination jeweils bewirkten Wellenfrontänderung voneinander unterscheiden; und
• wenigstens eine zweite Kontaminationsmarker-Struktur mit einer dritten Substruktur und einer vierten Substruktur, welche sich hinsichtlich der jeweils durch eine vorgegebene Kontamination bewirkten Wellenfrontänderung voneinander unterscheiden;
• wobei jede der Substrukturen in komplexer Kodierung wenigstens ein erstes Teilgitter zur Bereitstellung einer zur Interferogramm-Erzeugung beitragenden ersten Ausgangswelle und wenigstens ein Dummy-Gitter zur Erzeugung einer nicht zur Interferogramm-Erzeugung beitragenden Ausgangswelle aufweist;
• wobei sich die dritte Substruktur und/oder die vierte Substruktur sowohl von der ersten Substruktur als auch von der zweiten Substruktur hinsichtlich des Dummy-Gitters und/oder des relativen Gewichtes von Teilgittern und Dummy-Gitter und/oder des Füllfaktors voneinander unterscheiden;
• wobei die wenigstens zwei Kontaminationsmarker-Strukturen der Kontaminationsmarker-Anordnung jeweils im Wege einer modellbasierten Suche ermittelte Strukturen sind, wobei die Dummy-Struktur für ein vorgegebenes erstes Teilgitter zur Bereitstellung einer zur Interferogramm-Erzeugung beitragenden ersten Ausgangswelle durch die modellbasierte Suche numerisch optimiert ist.

2. Computer-generiertes Hologramm (CGH) nach Anspruch 1, **dadurch gekennzeichnet, dass** wenigstens eine der Kontaminationsmarker-Strukturen eine Kontaminations-Sensitivität besitzt, welche wenigstens das Zweifache, insbesondere wenigstens das Fünffache, weiter insbesondere wenigstens das Zehnfache, und weiter insbesondere wenigstens das Zwanzigfache der Kontaminations-Sensitivität der Nutzstruktur beträgt.

3. Computer-generiertes Hologramm (CGH) nach Anspruch 1 oder 2, **dadurch gekennzeichnet, dass** jede der Substrukturen dieser Kontaminationsmarker-Struktur bei einer in der Messanordnung durchgeführten interferometrischen Messung einen Interferenzkontrast von wenigstens 10 %, insbesondere wenigstens 30 %, weiter insbesondere wenigstens 50 %, weiter insbesondere wenigstens 70 % erzeugt.

4. Computer-generiertes Hologramm (CGH) nach einem der Ansprüche 1 bis 3, **dadurch gekennzeichnet, dass** die Kontaminationsmarker-Anordnung eine Mehrzahl von in einem Array angeordneten Kontaminationsmarker-Strukturen mit jeweils einer ersten Substruktur und einer zweiten Substruktur aufweist.

5. Computer-generiertes Hologramm (CGH) nach einem der vorhergehenden Ansprüche 1 bis 4, **dadurch gekennzeichnet, dass** jede der Substrukturen ferner ein zweites Teilgitter zur Bereitstellung einer zur Interferogramm-Erzeugung beitragenden zweiten Ausgangswelle als Referenzwelle aufweist.

6. Computer-generiertes Hologramm (CGH) nach Anspruch 5, **dadurch gekennzeichnet, dass** das zweite Teilgitter eine Littrow-Struktur ist.

7. Computer-generiertes Hologramm (CGH) nach einem der vorhergehenden Ansprüche, **dadurch gekennzeichnet, dass** dieses einen die wenigstens eine Nutzstruktur aufweisenden ersten Bereich und einen von diesem ersten Bereich räumlich separierten zweiten Bereich aufweist, wobei die Kontaminationsmarker-Anordnung in dem zweiten Bereich angeordnet ist.

8. Computer-generiertes Hologramm (CGH) nach einem der vorhergehenden Ansprüche, **dadurch gekennzeichnet, dass** dieses zum Prüfen eines optischen Elements einer mikrolithographischen Projektionsbelichtungsanlage ausgelegt ist.

9. Verfahren zur Auslegung eines Computer-generierten Hologramms (CGH) mit einer Kontaminationsmarker-Anordnung, wobei die Kontaminationsmarker-Anordnung eine erste Kontaminationsmarker-Struktur mit einer ersten Substruktur und einer zweiten Substruktur, welche sich hinsichtlich der durch eine vorgegebene Kontamination jeweils bewirkten Wellenfrontänderung voneinander unterscheiden, und wenigstens eine zweite Kontaminationsmarker-Struktur mit einer dritten Substruktur und einer vierten Substruktur, welche sich hinsichtlich der jeweils durch eine vorgegebene Kontamination bewirkten Wellenfrontänderung voneinander unterscheiden, aufweist, wobei jede der Substrukturen in komplexer Kodierung wenigstens ein erstes Teilgitter zur Bereitstellung einer zur Interferogramm-Erzeugung beitragenden ersten Ausgangswelle und wenigstens ein Dummy-Gitter zur Erzeugung einer nicht zur Interferogramm-Erzeugung beitragenden Ausgangswelle aufweist, wobei die wenigstens zwei Kontaminationsmarker-Strukturen der Kontaminationsmarker-Anordnung jeweils im Wege einer modellbasierten Suche ermittelt werden, wobei bei dieser modellbasierten Suche eine numerische Optimierung der Dummy-Struktur für ein vorgegebenes erstes Teilgitter zur Bereitstellung einer zur Interferogramm-Erzeugung beitragenden ersten Ausgangswelle durchgeführt wird.

10. Verfahren nach Anspruch 9, **dadurch gekennzeichnet, dass** diese numerische Optimierung derart durchgeführt wird, dass die Kontaminations-Sensitivität einer durch Überlagerung der wenigstens einen durch das CGH bereitgestellten ersten Ausgangswelle mit einer Referenzwelle in einer interferometrischen Messanordnung erzeugten Interferogrammphase unter vorgegebenen Randbedingungen maximiert wird.

11. Verfahren nach Anspruch 9 oder 10, **dadurch gekennzeichnet, dass** das CGH ein CGH nach einem der Ansprüche 1 bis 8 ist.

12. Interferometrische Messanordnung zum Prüfen eines optischen Elements, insbesondere eines optischen Elements einer mikrolithographischen Projektionsbelichtungsanlage, wobei die Messanordnung ein Computer-generiertes Hologramm (CGH) aufweist und wobei eine Prüfung zumindest einer Teilfläche des optischen Elements durch interferometrische Überlagerung einer von diesem Computer-generierten Hologramm auf das optische Element gelenkten Prüfwelle und einer Referenzwelle durchführbar ist, wobei das Computer-generierte Hologramm (CGH) nach einem der Ansprüche 1 bis 8 ausgelegt ist.

## Claims

1. Computer-generated hologram (CGH) for use in an interferometric measurement arrangement, having at least one used structure and a contamination marker arrangement for detecting contamination present on the CGH, wherein said contamination marker arrangement has:
• a first contamination marker structure having a first substructure and a second substructure which differ from one another in terms of the wavefront change respectively caused by predefined contamination; and
• at least one second contamination marker structure having a third substructure and a fourth substructure which differ from one another in terms of the wavefront change respectively caused by predefined contamination;
• wherein each of the substructures has, in complex coding, at least one first partial grating for providing a first output wave contributing to interferogram generation and at least one dummy grating for generating an output wave not contributing to interferogram generation;
• wherein the third substructure and/or the fourth substructure differ(s) both from the first substructure and from the second substructure in terms of the dummy grating and/or the relative weight of partial gratings and the dummy grating and/or the fill factor;
• wherein the at least two contamination marker structures of the contamination marker arrangement are structures determined in each case by way of a model-based search, wherein the dummy structure is numerically optimized by the model-based search for a predefined first partial grating for providing a first output wave contributing to interferogram generation.

2. Computer-generated hologram (CGH) according to Claim 1, **characterized in that** at least one of the contamination marker structures has a contamination sensitivity which is at least twice, in particular at least five times, more particularly at least ten times, and more particularly at least twenty times, the contamination sensitivity of the used structure.

3. Computer-generated hologram (CGH) according to Claim 1 or 2, **characterized in that** each of the substructures of this contamination marker structure generates an interference contrast of at least 10%, in particular at least 30%, more particularly at least 50%, more particularly at least 70%, in an interferometric measurement carried out in the measurement arrangement.

4. Computer-generated hologram (CGH) according to one of Claims 1 to 3, **characterized in that** the contamination marker arrangement has a plurality of contamination marker structures which are arranged in an array and each have a first substructure and a second substructure.

5. Computer-generated hologram (CGH) according to one of the preceding Claims 1 to 4, **characterized in that** each of the substructures furthermore has a second partial grating for providing a second output wave contributing to interferogram generation as a reference wave.

6. Computer-generated hologram (CGH) according to Claim 5, **characterized in that** the second partial grating is a Littrow structure.

7. Computer-generated hologram (CGH) according to one of the preceding claims, **characterized in that** said hologram has a first region having the at least one used structure and a second region spatially separated from said first region, wherein the contamination marker arrangement is arranged in the second region.

8. Computer-generated hologram (CGH) according to one of the preceding claims, **characterized in that** said hologram is designed to test an optical element of a microlithographic projection exposure apparatus.

9. Method for designing a computer-generated hologram (CGH) with a contamination marker arrangement, wherein the contamination marker arrangement has a first contamination marker structure having a first substructure and a second substructure which differ from one another in terms of the wavefront change respectively caused by predefined contamination, and at least one second contamination marker structure having a third substructure and a fourth substructure which differ from one another in terms of the wavefront change respectively caused by predefined contamination, wherein each of the substructures has, in complex coding, at least one first partial grating for providing a first output wave contributing to interferogram generation and at least one dummy grating for generating an output wave not contributing to interferogram generation, wherein the at least two contamination marker structures of the contamination marker arrangement are determined in each case by way of a model-based search, wherein the dummy structure is numerically optimized in this model-based search for a predefined first partial grating for providing a first output wave contributing to interferogram generation.

10. Method according to Claim 9, **characterized in that** this numerical optimization is carried out in such a way that the contamination sensitivity of an interferogram phase generated by superimposing a reference wave on the at least one first output wave provided by the CGH in an interferometric measurement arrangement is maximized under predefined boundary conditions.

11. Method according to Claim 9 or 10, **characterized in that** the CGH is a CGH according to one of Claims 1 to 8.

12. Interferometric measurement arrangement for testing an optical element, in particular an optical element of a microlithographic projection exposure apparatus, wherein the measurement arrangement has a computer-generated hologram (CGH), and wherein at least one partial area of the optical element can be tested by interferometrically superimposing a test wave guided by this computer-generated hologram onto the optical element and a reference wave, wherein the computer-generated hologram (CGH) is designed according to one of Claims 1 to 8.

## Revendications

1. Hologramme généré par ordinateur (CGH) destiné à être utilisé dans un ensemble de mesure interférométrique, comportant au moins une structure utile ainsi qu'un ensemble de marqueur de contamination destiné à détecter une contamination présente sur le CGH, ledit ensemble de marqueur de contamination comportant :
• une première structure de marqueur de contamination comportant une première sous-structure et une deuxième sous-structure, qui diffèrent l'une de l'autre quant à la modification de front d'onde respectivement provoquée par une contamination prédéfinie ; et
• au moins une deuxième structure de marqueur de contamination comportant une troisième sous-structure et une quatrième sous-structure, qui diffèrent l'une de l'autre quant à la modification de front d'onde provoquée respectivement par une contamination prédéfinie ;
• chacune des sous-structures comportant, dans un codage complexe, au moins une premier sous-réseau destiné à fournir une première onde de sortie contribuant à la génération d'interférogramme et au moins un réseau factice destiné à générer une onde de sortie ne contribuant pas à la génération d'interférogramme ;
• la troisième sous-structure et/ou la quatrième sous-structure différant à la fois de la première sous-structure et de la deuxième sous-structure quant au réseau factice et/ou au poids relatif des sous-réseaux et du réseau factice et/ou du facteur de remplissage ;
• les au moins deux structures de marqueur de contamination de l'ensemble de marqueur de contamination étant des structures déterminées respectivement au cours d'une recherche basée sur un modèle, la structure factice pour un premier sous-réseau prédéfini destiné à fournir une première onde de sortie contribuant à la génération d'interférogramme étant optimisée numériquement par la recherche basée sur le modèle.

2. Hologramme généré par ordinateur (CGH) selon la revendication 1, **caractérisé en ce qu'**au moins une des structures de marqueur de contamination possède une sensibilité à la contamination, qui est égale au moins à 2 fois, en particulier au moins à 5 fois, par ailleurs en particulier au moins à 10 fois, et par ailleurs en particulier au moins à 20 fois la sensibilité à la contamination de la structure utile.

3. Hologramme généré par ordinateur (CGH) selon la revendication 1 ou 2, **caractérisé en ce que** chacune des sous-structures de ladite structure de marqueur de contamination génère un contraste d'interférence d'au moins 10 %, en particulier d'au moins 30 %, par ailleurs en particulier d'au moins 50 %, par ailleurs en particulier d'au moins 70 % lors d'une mesure interférométrique mise en œuvre dans l'ensemble de mesure.

4. Hologramme généré par ordinateur (CGH) selon l'une des revendications 1 à 3, **caractérisé en ce que** l'ensemble de marqueur de contamination comporte une multitude de structures de marqueur de contamination disposées dans un réseau comportant respectivement une première sous-structure et une deuxième sous-structure.

5. Hologramme généré par ordinateur (CGH) selon l'une des revendications précédentes 1 à 4, **caractérisé en ce que** chacune des sous-structures comporte en outre un deuxième sous-réseau destiné à fournir une deuxième onde de sortie contribuant à la génération d'interférogramme en tant qu'onde de référence.

6. Hologramme généré par ordinateur (CGH) selon la revendication 5, **caractérisé en ce que** le deuxième sous-réseau est une structure de Littrow.

7. Hologramme généré par ordinateur (CGH) selon l'une des revendications précédentes, **caractérisé en ce que** celui-ci comporte une première zone comportant l'au moins une structure utile et une deuxième zone séparée spatialement de ladite première zone, l'ensemble de marqueur de contamination étant disposé dans la deuxième zone.

8. Hologramme généré par ordinateur (CGH) selon l'une des revendications précédentes, **caractérisé en ce que** celui-ci est conçu pour vérifier un élément optique d'une installation d'exposition par projection microlithographique.

9. Procédé de conception d'un hologramme généré par ordinateur (CGH) avec un ensemble de marqueur de contamination, l'ensemble de marqueur de contamination comportant une première structure de marqueur de contamination comportant une première sous-structure et une deuxième sous-structure, qui diffèrent l'une de l'autre quant à une modification de front d'onde respectivement provoquée par une contamination prédéfinie, et au moins une deuxième structure de marqueur de contamination comportant une troisième sous-structure et une quatrième sous-structure, lesquelles diffèrent l'une de l'autre quant à la modification de front d'onde provoquée respectivement par une contamination prédéfinie, chacune des sous-structures comportant dans un codage complexe au moins un premier sous-réseau destiné à fournir une première onde de sortie contribuant à la génération d'interférogramme et au moins un réseau factice destiné à générer une onde de sortie ne contribuant pas à la génération d'interférogramme, les au moins deux structures de marqueur de contamination de l'ensemble de marqueur de contamination étant déterminées respectivement au cours d'une recherche basée sur un modèle, une optimisation numérique de la structure factice pour un premier sous-réseau prédéfini destiné à fournir une première onde de sortie contribuant à la génération d'interférogramme étant mise en œuvre lors de ladite recherche basée sur un modèle.

10. Procédé selon la revendication 9, **caractérisé en ce que** ladite optimisation numérique est mise en œuvre de telle manière que la sensibilité à la contamination d'une phase d'interférogramme générée par superposition de l'au moins une première onde de sortie fournie par le CGH comportant une onde de référence dans un ensemble de mesure interférométrique est maximisée dans des conditions marginales prédéfinies.

11. Procédé selon la revendication 9 ou 10, **caractérisé en ce que** le CGH est un CGH selon l'une des revendications 1 à 8.

12. Ensemble de mesure interférométrique destiné à vérifier un élément optique, en particulier un élément optique d'une installation d'exposition par projection microlithographique, l'ensemble de mesure comportant un hologramme généré par ordinateur (CGH) et une vérification d'au moins une surface partielle de l'élément optique pouvant être mise en œuvre par superposition interférométrique d'une onde de vérification dirigée sur l'élément optique par ledit hologramme généré par ordinateur et d'une onde de référence, l'hologramme généré par ordinateur (CGH) étant conçu selon l'une des revendications 1 à 8.
